# EUROPEAN PATENT APPLICATION

(11) **EP 1 608 212 A2**
(43) Date of publication of application: **21.12.2005**
(21) Application number: 05012925.3
(22) Date of filing: 15.06.2005
(51) Int. Cl.: H05K 13/04

(54) **Electronic component mounting apparatus and electronic component mounting method**

(30) Priority: 15.06.2004 JP 2004176742
(71) Applicant: Hitachi High-Tech Instruments Co., Ltd., Ora-gun, Gunma-ken, 370-0596 (JP)
(72) Inventor: Takemura, Ikuo, Gunma (JP); Okamoto, Manabu, Gunma (JP); Iida, Sigeru, Gunma (JP); Onishi, Seiji, Gunma (JP); Asai, Jun, Gunma (JP)
(74) Representative: Glawe, Delfs, Moll

(57) **Abstract**

Recognition of a position of a printed board is performed both before and after a chip component is mounted on the printed board. When a difference between the positions recognized before and after that is out of a predetermined allowable range, the printed board is treated as a defective. A CPU (61) compares positions of a positioning mark provided on a printed board recognized both before and after a chip component is mounted on the printed board, the positions being taken an image by a board recognition camera (70) and recognized by a recognition processing device (68). The CPU (61) checks whether or not a difference between the positions is within a predetermined range stored in a RAM (62), that is, within a range from - 0.100 mm to + 0.100 mm, in both X and Y directions. When judging that the difference is within the range, the CPU (61) controls an electronic component mounting apparatus to stop because of an error.

## Description

### CROSS-REFERENCE OF THE INVENTION

This invention is based on Japanese Patent Application No. 2004-176742.

### BACKGROUND OF THE INVENTION

### Field of the Invention:

The invention relates to an electronic component mounting apparatus and an electronic component mounting method where an electronic component is mounted on a printed board after a board recognition camera takes an image of a positioning mark on the printed board and a recognition processing device recognizes the image taken by the board recognition camera.

### Description of the Related Art:

This kind of electronic component mounting apparatus has been known through the Japanese Patent Application Publication No. 2003-318600 and so on. In this electronic component mounting apparatus, electronic components are mounted on the printed board after the position of the printed board already positioned is recognized by the board recognition camera. After all the electronic components are mounted on the printed board, the printed board is discharged to a downstream device.
However, when the printed board is unstably positioned due to a mistakenly replaced positioning member for positioning the printed board or positioned being warped (e.g. warped upward), since the electronic component is mounted on the unstable printed board or mounted on the warped printed board which is supposed to be straight, the position where the electronic component is mounted can be shifted from a proper position on the printed board. These occur because the electronic component is mounted thereon after the position of the printed board is recognized. It in an object of this invention to provide an electronic component mounting apparatus and method that avoids a negative impact on product quality by such unstable or warped boards.

### SUMMARY OF THE INVENTION

The solution according to the invention lies in the features of the independent claims and preferably in those of the dependent claims.

The invention provides an electronic component mounting apparatus that includes a board recognition camera taking an image of a positioning mark on a printed board, a recognition processing device determining a position of the positioning mark based on the image of the positioning mark taken by the board recognition camera, a mounting unit mounting an electronic component on the printed board based on the position of the positioning mark determined by the recognition processing device, and a control device that makes the board recognition camera take a first image of the positioning mark before any electric component is mounted on the printed board and take a second image of the positioning mark after an electronic component is mounted on the printed board, makes the recognition processing device determine a first position of the positioning mark based on the first image and determine a second position of the positioning mark based on the second image, compares the first and second positions, and emits a fault signal. The fault signal can be processed such that it stops mounting the electronic component when a difference between the first and second positions is out of a predetermined allowable range. The fault signal may be used by the control device to inform an operator of the difference between the first and second positions, rather than stopping the operation.

The invention also provides a method of mounting an electronic component. The method includes providing a printed board having a positioning mark, taking a first image of the positioning mark before any electric component is mounted on the printed board, determining a first position of the positioning mark based on the first image, taking a second image of the positioning mark after an electronic component is mounted on the printed board, determining a second position of the positioning mark based on the second image, comparing the first and second positions, and emits a fault signal. It stops a mounting operation of the electronic component when a difference between the first and second positions is out of a predetermined allowable range. An operator may be informed of the difference, rather then the operation being stopped.

### BRIEF DESCRIPTION OF THE DRAWINGS

Fig. 1 is a plan view of an electronic component mounting apparatus of the invention.
Fig. 2 is a plan view of a conveying chute of the invention.
Fig. 3 is a left side view of the conveying chute and an XY table of the invention.
Fig. 4. is a side view of the fixed conveying chute seen from an arrow X of Fig. 2.
Fig. 5 is a side view of the fixed conveying chute being on standby seen from the arrow X of Fig. 2.
Fig. 6 is a side view of the movable conveying chute being on standby seen from an arrow Y of Fig. 2.
Fig. 7 is a side view of the fixed conveying chute seen from the arrow X of Fig. 2.
Fig. 8 is a left side view of the conveying chute and the XY table of the invention.
Fig. 9 is a side view of the fixed conveying chute in a state that a printed board lies thereon and a cylinder is operated, seen from the arrow X of Fig. 2.
Fig. 10 is a side view of the movable conveying chute in a state that the printed board lies thereon and the cylinder is operated, seen from the arrow Y of Fig. 2.
Fig. 11 is a side view of the fixed conveying chute in a state that no printed board lies thereon and the cylinder is operated, seen from the arrow X of Fig. 2.
Fig. 12 is a side view of the movable conveying chute in a state that no printed board lies thereon and the cylinder is operated, seen from the arrow Y of Fig. 2.
Fig. 13 is a view showing a relationship between a light shield board, a sensor attachment body, and a detection sensor.
Fig. 14 is a control block diagram.
Fig. 15 is a view of a screen of a monitor for setting a board re-recognition-check-stop function.
Fig. 16 is a view of the monitor when an electronic component is judged defective.

### DETAILED DESCRIPTION OF THE INVENTION

An embodiment of an electronic component mounting apparatus for mounting a chip-type electronic component on a printed board of the invention will be described in detail with reference to drawings hereafter. A numeral 1 designates a Y table moving in a Y direction by rotation of a Y axis drive motor 2, and a numeral 3 designates a XY table moving in X and Y directions by moving in the X direction on the Y table 1 by rotation of a X axis drive motor 4, where a printed board 6 to be mounted with a chip-type electronic component 5 (hereafter, called "chip component" or "component") is set by being fixed to a pair of conveying chutes 31 and 32 by a fixing device (not shown).

A numeral 7 designates a feeding stage which is provided with many component feeding units 8 for feeding the chip components 5. A numeral 9 designates a feeding stage drive motor which rotates a ball screw 10 to move the feeding stage 7 in the X direction along linear guides 12 through a nut (not shown) engaged with the ball screw 10 and fixed to the feeding stage 7. A numeral 13 designates a rotary table intermittently rotating itself. On an outer circumference of the table 13, mounting heads 15 having a plurality of suction nozzles (not shown) are provided at predetermined intervals corresponding to intermittent pitches.

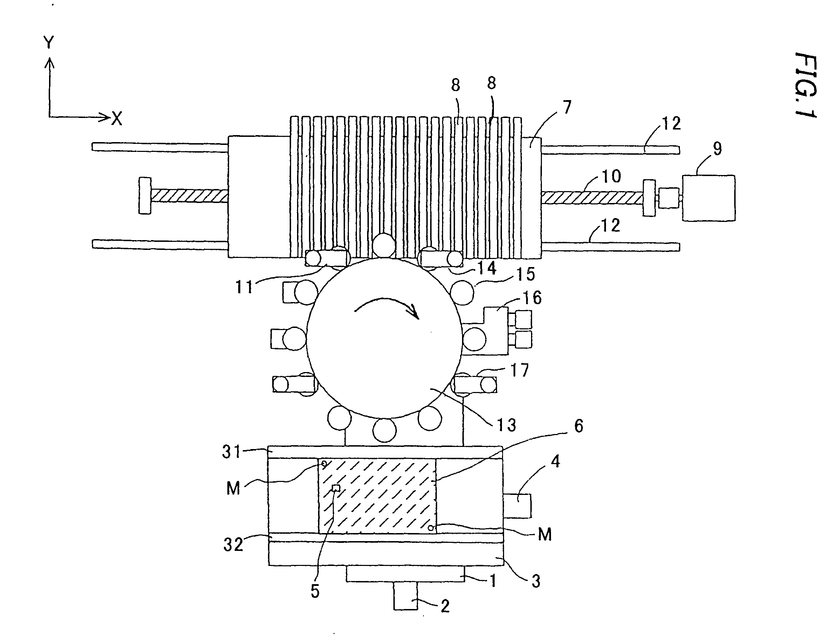

A position where the mounting head 15 stops for picking up the component 5 by suction from the component feeding unit 8 by its suction nozzle (a position of 12 o'clock in Fig. 1) is a pickup station. At the pickup station, the suction nozzle picks up the component 5 by suction.

A position where the mounting head 15 stops previous to the pickup position, is a pickup correction station where a pickup correction device 11 corrects a position of the suction nozzle in a Y direction which is a direction of directly going to the moved feeding stage 7.

A position where the mounting head 15 stops next to the pickup position, is a rotation returning position, where a rotation returning device 14 returns the suction nozzle, of which the position is corrected at the pickup correction station so as to pick up the center of the component 5 by suction, to an original position.

A numeral 16 designates a component recognition camera that takes an image of a bottom surface of the component 5 held by suction by the suction nozzle. A position where the mounting head 15 stops above the component recognition camera 16 while the rotary table 13 rotates is a recognition station.

A position where the mounting head 15 stops next to the recognition station is a angle correction station, where a positional shift of the component 5 held by suction by the suction nozzle is corrected in an rotation angle by rotating the mounting head 15 in a θ direction by a head rotation device 17 having a θ axis drive motor 17A based on a recognition result of the image taken by the component recognition camera 16.

A second stop position from the angle correction station, is a mounting station, where the component 5 held by suction by the suction nozzle is mounted on the printed board 6.

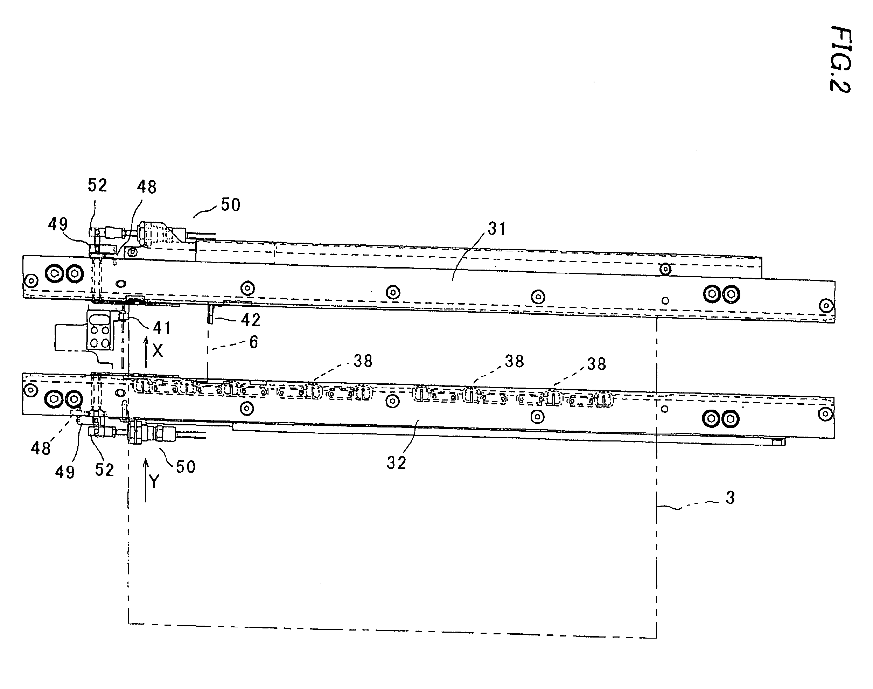

In Figs. 2 to 5, numerals 31 and 32 designate a pair of conveying chutes supported by chute supporting members (not shown). In each of the conveying chutes 31 and 32, a conveying belt 35 is stretched between sprockets 34 (only one sprocket is shown) provided at least in left and right end portions. The sprockets 34 are rotated by drive sources, so that the conveying belts 35 convey the printed board 6 of which left and right ends are set on the conveying belts 35. Numerals 38 designate pressing members provided in the movable conveying chute 32 at predetermined intervals, which press the printed board 6 to the fixed conveying chute 31.

The XY table 3 is disposed below the printed board 6, and movable in the X and Y directions by the X axis drive motor 4 and the Y axis drive motor 2 on a horizontal plane. A front surface of the XY table 3, which faces the printed board 6, is provided with a plurality of holes (not shown). Backup pins 37 for supporting the printed board 6 horizontally by being in contact with a back surface of the printed board 6 are provided on the XY table 3 by being inserted in the holes appropriate for forming the size of the printed board 6, being pullable from the holes.

As shown in the Japanese utility model application publication No. hei 6-52197, chute vertical movement levers each having a roller in its end are rotatably set in bearings fixed to the XY table 3, although not shown. By vertically moving the rollers of the chute vertical movement levers by cylinders, the printed board 6 supported by the conveying chutes 31 and 32 are vertically moved together with the chute supporting members. The chute supporting members vertically move, being guided by guide shafts penetrating the XY table 3.

A supply conveyer having a belt moved by a drive motor is provided on an upstream side of the XY table 3, and a discharge conveyer having a belt moved by a drive motor is provided on a downstream side of the XY table 3. With the board conveying chutes 31 and 32 raised, the printed board 6 on the supply conveyer is shifted onto the XY table 3, and the printed board 6 on the XY table 3 is shifted onto the discharge conveyer.

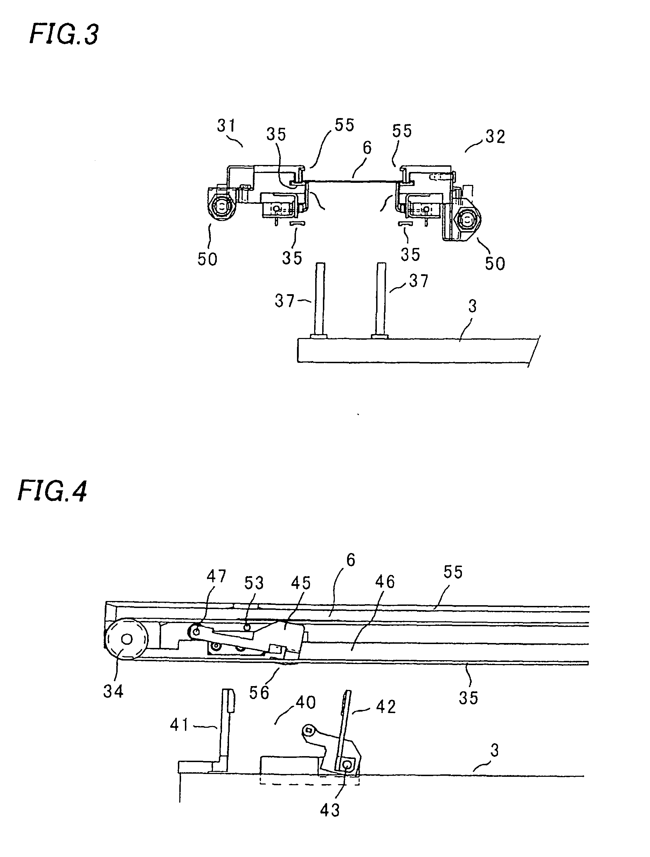

Next, a positioning device 40 for the printed board 6 will be described with reference to Fig. 4. The positioning device 40 includes a pair of positioning pins 41 and 42 provided on the XY table 3. The positioning pin 41 is fixed to the XY table 3, and can be in contact with a rear end of the printed board 6 in a conveying direction. The positioning pin 42 is fixed to the XY table 3, being rotatable around a supporting axis 43 as a fulcrum and movable so as to have a space between the pins 41 and 42 corresponding to a transverse size of the printed board 6. When rotated, the positioning pin 42 becomes in contact with a front end of the printed board 6 in the conveying direction.

In detail, when the board conveying chutes 31 and 32 descend, the positioning pin 42 is rotated by a drive source (not shown), and holds the printed board 6 with the positioning pin 41, pressing the board 6 to the positioning pin 41, so that the printed board 6 is positioned.

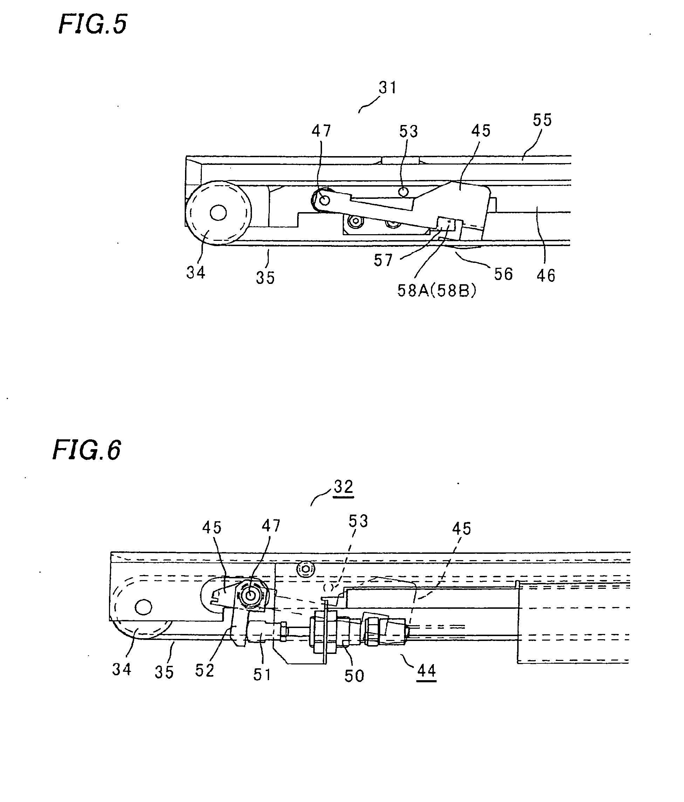

A numeral 44 shown in Fig. 6 designates a detection device for detecting presence or absence of the printed board 6, which is provided in each of the conveying chutes 31 and 32. The detection device 44 will be described in detail below. A numeral 45 designates a detection lever of which one end is supported by a chute body 46, being rotatable around a support axis 47. The detection lever 45 is being pressed upward by fastening an end of a coil spring 48, which is wound around the supporting axis 47, to a fixing member 49 fixed to the supporting axis 47 and by fastening another end of this spring 48 to the chute body 46. Upward rotation of the detection lever 45 is regulated by an operation lever 52 fixed to the supporting axis 47, the operation lever 52 being in contact with an extended rod 51 of a cylinder 50.

When the cylinder 50 is operated, the rod 51 is drawn in the cylinder 50, so that the detection lever 45 rotates upward by the coil spring 48. The detection lever 45 then becomes in contact with the regulation pin 53, and its upper end level is regulated in a position slightly higher than a guide surface of an upper board of the conveying chute (a lower surface of a block portion 55). However, in a case that the printed board 6 lies on the conveying belt 35 when the detection lever 45 rotates upward by the operation of the cylinder 50, upper portions of the detection levers 45 on the other side push the printed board 6 upward and press it to the block portions 55 formed in the conveying chutes 31 and 32, so that the printed board 6 can be positioned in a vertical direction.

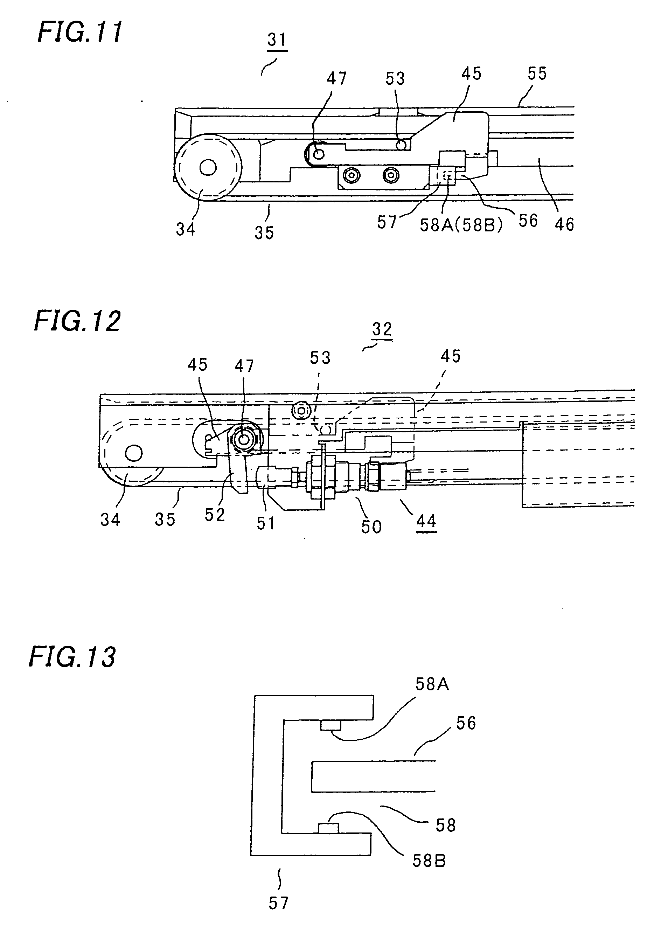

Furthermore, a light shield board 56 is provided in a lower portion of the detection lever 45 on the other side, and a sensor attachment body 57 formed in a U-shape in its cross-section is provided in the chute body 46, where an emissive element 58A is provided on one of attachment boards facing each other of the sensor attachment body 57 and a light receiving element 58B is provided on another one of the attachment boards (Fig. 13), forming a detection sensor 58.

That is, in a case that the printed board 6 is positioned in the vertical direction by pushing and pressing the board 6 to the block portions 55 from downward by the upper portions of the detection levers 45 on the other side when the detection levers 45 are rotated upward by the operation of the cylinders 50, the light shield boards 56 do not lie in upper bound positions, so that the light receiving elements 58B receive light from the emissive elements 58A and the detection sensors 58 recognize the printed board's presence. On the other hand, in a case that the printed board 6 is slipped from the conveying chutes 31 and 32 or partially defective when positioned, at least one of the detection levers 45 provided in the chutes 31 and 32 rotates upward until it becomes in contact with the regulation pin 53. Therefore, light from the emissive element 58A is shielded by the light shield board 56 in the upper bound position and the receiving element 58B does not receive light from the emissive element 58A, so that the detection sensor 58 recognizes the printed board 6 as absence.

In a mounting operation, in a state that the backup pins 37 become in contact with the back surface of the printed board 6 by descending the conveying chutes 31 and 32 and the printed board 6 is pressed toward the block portions 55 from downward by the upper end portions of the detection levers 45 rotated, the component suction nozzle as a mounting device holding the component 5 supplied from the component feeding unit 8 descends to a predetermined position on the printed board 6 while the printed board 6 is moved in the horizontal direction by the XY table 3, and mounts the component 5 on the printed board 6.

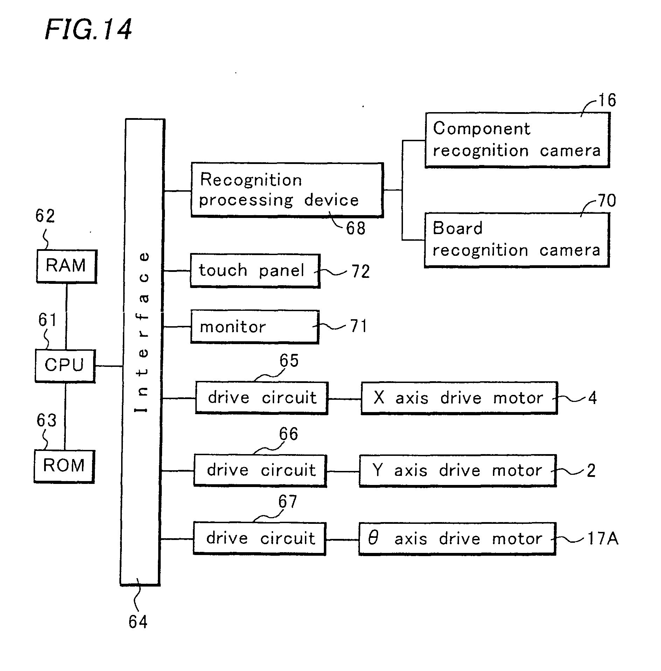

Next, description will be made based on a control block diagram of Fig. 14. The electronic component mounting apparatus includes a CPU 61 serving as a control portion controlling a component mounting operation of the apparatus, and a RAM (random access memory) 62 and a ROM (read only memory) 63 as memories.

The RAM 62 is stored with mounting data for each of types of the printed board 6, which includes information about X and Y directions on the printed board 6 and an angle in mounting order (in order of step number), and alignment numbers of the component feeding units 8. Furthermore, the RAM 62 is stored with information on types of the chip components (component ID) corresponding to the alignment numbers (lane numbers) of the component feeding units 8, that is, the component alignment information, and component library data on features of the chip components for each of the component IDs.

Then, the CPU 61 controls the component mounting operation of the electronic component mounting apparatus based on data stored in the RAM 62 and according to a program stored in the ROM 63. That is, the CPU 61 controls driving of the X axis drive motor 4, the Y axis drive motor 2, and the θ axis drive motor 17A, respectively through a drive circuit 65, a drive circuit 66, and a drive circuit 67.

A numeral 68 designates a recognition processing device connected with the CPU 61 through an interface 64. The recognition processing device 68 performs a recognition process to images taken and stored by the component recognition camera 16, and sends a recognition result to the CPU 61. That is, the CPU 61 outputs a command to perform the recognition process (e.g. calculation of a shifting amount of an electronic component from a proper position) to the image taken and stored by the component recognition camera 16 to the recognition processing device 68, and receives a recognition result from the recognition processing device 68.

A numeral 70 designates a board recognition camera that takes an image of positions of positioning marks M provided on the printed board 6. The recognition processing device 68 recognizes the image taken and thus the position of the printed board 6. That is, the recognition processing device 68 recognizes the image taken and stored by the board recognition camera 70, and sends a recognition result to the CPU 61. That is, the CPU 61 outputs a command to perform the recognition process (e.g. calculating a shifted amount from a proper position) to the image taken by the board recognition camera 70 to the recognition processing device 68, and receives a recognition result from the recognition processing device 68.

In detail, when the recognition processing device 68 recognizes the shifting amounts of the printed board 6 and the chip component 5 held by the suction nozzle from proper positions, the recognition result is sent to the CPU 61. The CPU 61 moves the XY table 3 in the X and Y directions by driving the X axis drive motor 4 and the Y axis drive motor 2, and rotates the mounting head 15 (suction nozzle) by a θ angle by driving the θ axis drive motor 17A, thereby completing correction in the X and Y directions and in the rotating angle around a vertical axis.

A monitor (CRT) 71 displays the images that are taken by the component recognition camera 16 and the board recognition camera 70 and stored in the recognition processing device 68. Various touch panels 72 are provided on the monitor 71, as an input device for setting data. An operator can perform various settings by operating the touch panel switches 72. A keyboard can be also used as the input device for setting data, instead.

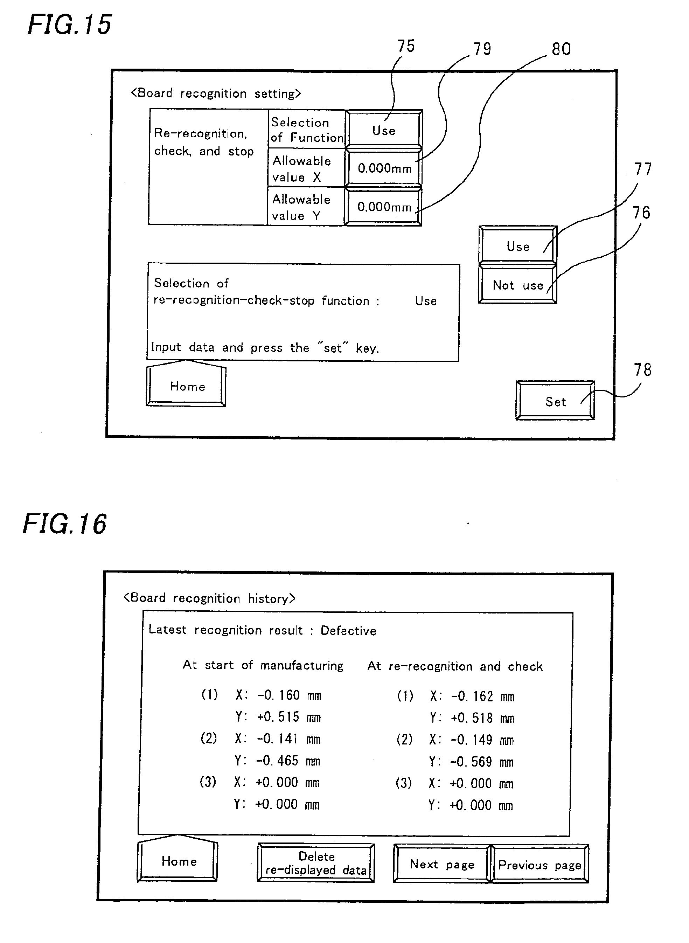

Hereafter, a setting operation of a board re-recognition-check-stop function will be described. On a monitor 71 displaying a screen shown in Fig. 15, selection is made on whether or not a board re-recognition-check-stop function is to be used, first. That is, after pressing an operation switch portion 75 next to a "selection of function" portion, the operator presses a "not use" operation switch portion 76 when an ordinary manufacturing operation is to be performed or presses a "use" operation switch portion 77 when the board re-recognition-check-stop function is to be activated. In this embodiment, since the board re-recognition-check-stop function is to be activated, the "use" operation switch portion 77 is pressed and then a "set" operation switch portion 78 is pressed.

After the printed board 6 is positioned on the XY table 3, the board recognition process is performed before the chip component 5 is mounted on the printed board 6 and also performed after the chip component 5 is mounted thereon. Both the positions of the positioning mark M, which are recognized before and after the component 5 is mounted on the printed board 6, are compared to judge whether or not a deference between these positions is within a predetermined range. When the difference is out of the predetermined range, the mounting apparatus is stopped because of an error. The board re-recognition-check-stop function works in this manner.

Next, description will be made on an operation of setting an allowable value for determining the predetermined range. First, when setting an allowable value X, the operator presses an operation switch portion 79 next to an "allowable value X" portion on the monitor. Then, a number operation switch portion (not shown) is displayed in a position where the "use" operation switch portion 77 and the "not use" operation switch portion 76 are displayed in the screen shown in Fig. 15. The operator inputs 0.100 mm, for example, by pressing the number operation switch portion, and presses the "set" operation switch portion 78.

When setting an allowable value Y, the operator presses an operation switch portion 80 next to an "allowable value Y" portion. Then, as described above, the number operation switch portion (not shown) is displayed in the position where the "use" operation switch portion 77 and the "not use" operation switch portion 76 are displayed in the screen shown in Fig. 15. The operator inputs 0.100 mm, for example, by pressing the number operation switch portion, and presses the "set" operation switch portion 78.

The allowable values X and Y thus set is stored in the RAM 62. The CPU 61 compares both the positions of the positioning mark M recognized before and after the component 5 is mounted on the printed board 6, and checks whether or not the difference of these positions is within the predetermined range, that is, within a range from -0.100 mm to + 0.100 mm, in both the X and Y directions. When the difference is out of the predetermined range, the CPU 61 stops the electronic component mounting apparatus because of an error. The board re-recognition-check-stop function works in this manner.

With this structure, the operation of the electronic component mounting apparatus will be described hereafter. First, when a printed board 6 is shifted onto the supply conveyer from the upstream device (not shown), a printed board 6 on the supply conveyer is shifted onto the XY table 3 and a printed board 6 on the XY table 3 is shifted onto the discharge conveyer.

That is, by rotation of conveying belts of the supply conveyer, the XY table 3, and the discharge conveyer, each of the printed boards 6 thereon is shifted to next one among these.

Then, as the rods of the cylinders (not shown) descend, the chute vertical movement levers rotate downward, and the printed board 6 supported by the conveying chutes 31 and 32 by the guide shafts descends together with the conveying chutes 31 and 32 and the chute supporting members.

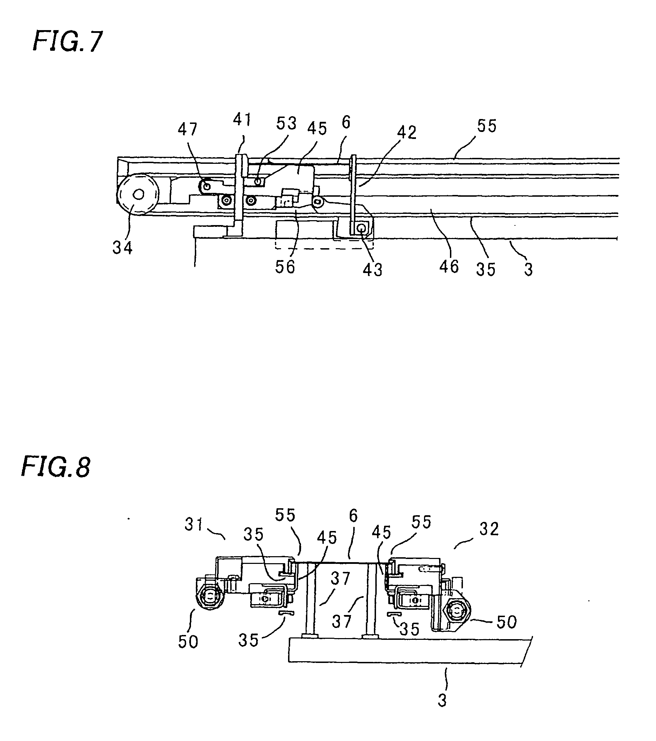

By the conveying chutes 31 and 32 descending, the backup pins 37 inserted in the holes formed in the XY table 3 become in contact with the back surface of the printed board 6 to push and support the printed board 6 horizontally. Even if warped downward, the printed board 6 can be held straight by the backup pins 37 pushing the warped portion (Fig. 8).

Furthermore, when the conveying chutes 31 and 32 descend, the positioning pin 42 is rotated by the drive source (not shown), and pushes the printed board 6 to the positioning pin 41 to fix it between the pins 41 and 42, thereby positioning the printed board 6 in a lateral direction (in a conveying direction) (Figs. 4 and 7).

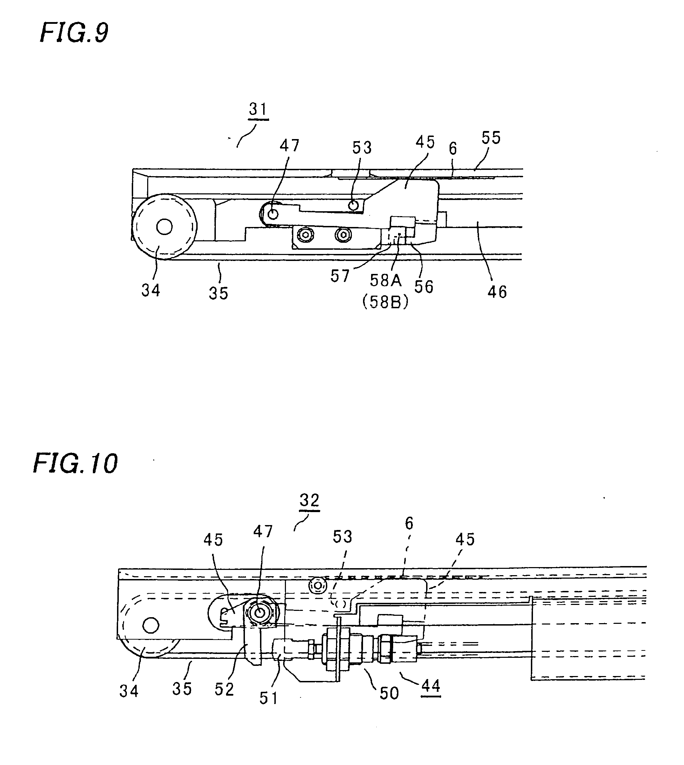

Furthermore, when the conveying chutes 31 and 32 finish descending, the cylinders 50 are activated to draw the rods 51 therein, the detection levers 45 rotate around the supporting axes 47 as fulcrums by pressure of the coil springs 48, and thus the another end sides of the detection levers 45 which are the opposite side of the supported side thereof rise up. When the printed board 6 lies on the conveying belts 35, the upper portions of another ends of the detection levers 45 push the printed board 6 up and press the printed board 6 to the block portions 55 formed in the conveying chutes 31 and 32 from downward, so that the printed board 6 is positioned in the vertical direction at its left and right ends (Figs. 9 and 10).

In this case that the printed board 6 is positioned by being pushed and pressed to the block portion 55 from downward by the upper portions of another end sides of the detection levers 45 when the detection lever 45 is rotated upward by the operation of the cylinder 50, the light shield boards 56 do not lie in the upper bound positions, so that the light receiving elements 58B receive light from the emissive elements 58A. Therefore, the detection sensors 58 recognize the printed board's presence.

Since the detection sensors 58 recognize the printed board's presence, the XY table 3 and the printed board 6 are moved in the X and Y directions driven by the Y axis drive motor 2 and the X axis drive motor 4 with the printed board 6 pressed to the fixed conveying chute 31 by the pressing members 38 provided in the movable conveying chute 32 and supported at its back surface by the backup pins 37 on the XY table 3, so that the board recognition camera 70 takes an image of the positioning marks M provided on the printed board 6. Therefore, the recognition processing device 68 performs a recognition process to the image taken by the board recognition camera 70 to recognize the positions of the positioning marks M and the printed board 6, and the positions of the positioning marks M and the printed board 6 are stored in the RAM 62. That is, the recognition processing device 68 performs the recognition process to the image taken by the board recognition camera 70, and the recognition result is sent to the CPU 61.

Then, at the pickup station, the suction nozzle picks up the chip component fed by the predetermined component feeding unit 8. When the mounting head 15 having the suction nozzle stops at above the component recognition camera 16 while the rotary table 13 sequentially rotates, the component recognition camera 16 takes an image of a bottom surface of the component 5 held by the suction nozzle. Then, the recognition processing device 68 performs the recognition process to the image taken by the component recognition camera 16 to recognize the position of the chip component 5. That is, the recognition processing device 68 performs the recognition process to the image taken by the component recognition camera 16, and the recognition result is sent to the CPU 61.

Accordingly, the recognition result of the position of the printed board 6 calculated by the recognition processing device 68 is added to the positional shifting amount of the chip component 5 held by the suction nozzle. Thus, the CPU 61 which receives the results moves the XY table 3 in the X and Y directions by driving the X axis drive motor 4 and the Y axis drive motor 2, and rotates the mounting head 15 (suction nozzle) by a θ angle by driving the θ axis drive motor 17A, thereby completing correction in the X and Y directions and in the rotation angle around the vertical axis.

In this manner, with the mounting head 15 and the printed board 6 set in corrected positions, the chip component 5 is mounted on the printed board 6 according to the mounting data stored in the RAM 62. When all the chip components 5 are mounted on the printed board 6 according to the mounting data, the XY table 3 is moved and the board recognition camera 70 takes an image of the positioning marks M provided on the printed board 6 again. The recognition processing device 68 then performs the recognition process to the image taken, and the positions of the marks M are stored in the RAM 62.

Then, the CPU 61 compares both the positions of each of the positioning marks M recognized before and after the component 5 is mounted on the printed board 6, and checks whether or not the difference between the positions is within the predetermined range stored in the RAM 62, that is, within the range from - 0.100 mm to + 0.100 mm, in both the X and Y directions. When the difference is within the range, the ordinary operation is performed.

In the ordinary operation, the XY table 3 returns to its original position. As the cylinders (not shown) is operated to raise the rods, the chute vertical movement levers rotate upward and the conveying chutes 31 and 32 and the chute supporting members rise up together, supporting the printed board 6 by the guide shafts. Then, by rotation of conveying belts of the supply conveyer, the XY table 3, and the discharge conveyer, each of the printed boards 6 thereon is shifted onto next one among these. The printed board 6 supported by the conveying chutes 31 and 32 is shifted onto the discharge conveyer and then to the upstream device.

On the other hand, as described above, in the case that the difference is out of the range when the CPU 61 checks whether or not the difference of both the positions of each of the positioning marks M before and after the component 5 is mounted on the printed board 6 is within the predetermined range stored in the RAM 62, that is, within the range from - 0.100 mm to + 0.100 mm, in both the X and Y directions, the CPU 61 controls the electronic component mounting apparatus to stop because of an error. That is, the mounting apparatus stops transferring thus identified printed board to the downstream process and mounting operation to the next printed board. Then, the operator of the mounting apparatus operates on the touch panel to transfer the identified printed board to a position for recovering the identified printed board. After the identified printed board is recovered, the operator operates on the touch panel to resume the component mounting operation. Alternatively, the operate may just place on the identified printed board a marking to indicate defective printed board and resume the component mounting operation. In this embodiment, the reference to determine the positions of the printed boards is the mounting apparatus itself.

When the difference is out of the range, this is displayed on the monitor 71 as shown in Fig. 16. That is, on the monitor 71, an upper row of (1) shows both X coordinates of one of the positioning marks M recognized when the manufacturing process starts (before the component is mounted on the printed board 6) and when the re-recognition process is performed (after the component is mounted on the printed board 6). A lower row of (1) shows both Y coordinates of one of the positioning marks M recognized when the manufacturing process starts (before the component is mounted on the printed board 6) and when the re-recognition process is performed (after the component is mounted on the printed board 6). An upper row of (2) shows both X coordinates of another one of the positioning marks M recognized when the manufacturing process starts (before the component is mounted on the printed board 6) and when the re-recognition process is performed (after the component is mounted on the printed board 6). A lower row of (2) shows both Y coordinates of another one of the positioning marks M recognized when the manufacturing process starts (before the component is mounted on the printed board 6) and when the re-recognition process is performed (after the component is mounted on the printed board 6). On this monitor 71, the Y coordinate of another one of the positioning marks M can be recognized as shifted by 0.104 mm, so that "defective" is displayed on the monitor 71 as a latest recognition result. It is noted that when such an error occurs, the error is not limited to be informed visually and can be informed auditorily by an informing device such as by voice or a buzzer.

When an improper positioning pin 42 for a printed board 6 is placed in the XY table 3, the positioning of the printed board 6 is not stable and as a result the mounting position with respect to the printed board 6 may shift from a predetermined position. Likewise, when the printed bard 6 is warped upward and positioned for component mounting, the descending suction nozzle pushes down a portion of the printed board 6 that is located at a level higher than a proper horizontal level because of the wrapping. As a result, the printed board 6 is pushed out of the proper position for the component mounting. In this embodiment, however, the printed board 6 manufactured in this manner can be treated as a defective, so that only the printed boards having high mounting accuracy can be manufactured. That is, after the electronic component mounting apparatus stops and the informing device informs the operator of that, the operator removes the causes of the error (e.g. mistakenly replaced positioning members) so that only the printed boards having higher mounting accuracy can be manufactured.

Although the above embodiment uses the XY table 3 that can move to any position in the X and Y directions on a horizontal plane and a suction nozzle that vertically moves at a determined position, a table that does not move in the horizontal direction can be used instead of the XY table 3 when the suction nozzle can move vertically and also in the X and Y directions on the horizontal plane.

Furthermore, the embodiment is applied to the electronic component automatic mounting apparatus, modifications are possible as long as these are within the scope of the invention. For example, the invention can be applied to a coating device (i.e. a so-called dispenser device) for coating a coating agent such as a desiccant on a board and so on.

Although particular preferred embodiment of the invention has been disclosed in detail, it will be recognized that variations or modifications of the invention are possible based on the disclosure and lie within the scope of the invention.

## Claims

1. An electronic component mounting apparatus comprising:
a board recognition camera (70) taking an image of a positioning mark on a printed board (6);
a recognition processing device (68) determining a position of the positioning mark (11) based on the image of the positioning mark (11) taken by the board recognition camera (70);
a mounting unit (15) mounting an electronic component on the printed board (6) based on the position of the positioning mark (11) determined by the recognition processing device (68); and
a control device (61) that makes the board recognition camera (70) take a first image of the positioning mark (11) before any electric component (5) is mounted on the printed board (6) and take a second image of the positioning mark (11) after an electronic component (5) is mounted on the printed board (6), makes the recognition processing device (68) determine a first position of the positioning mark (11) based on the first image and determine a second position of the positioning mark (11) based on the second image, compares the first and second positions, and emits a fault signal for the mounting unit (15) and/or for presentation to an operator.

2. The electronic component mounting apparatus of claim 1, wherein the fault signal stops mounting the electronic component when a difference between the first and second positions is out of a predetermined allowable range.

3. An electronic component mounting apparatus of claim 1, wherein the fault signal informs the operator of a difference between the first and second positions when the difference between the first and second positions is out of a predetermined allowable range.

4. The electronic component mounting apparatus of claim 3, further comprising an image display (71) that shows the operator the difference between the first and second positions when the difference between the first and second positions is out of the predetermined allowable range.

5. The electronic component mounting apparatus of claim 3 or 4, further comprising an audio device that warns the operator when the difference between the first and second positions is out of the predetermined allowable range.

6. The electronic component mounting apparatus according to any of claims 1 to 5, further comprising a memory (62) storing the predetermined allowable range therein.

7. A method of mounting an electronic component, comprising:
providing a printed board (6) comprising a positioning mark (11);
taking a first image of the positioning mark (11) before any electric component (5) is mounted on the printed board (6);
determining a first position of the positioning mark (11) based on the first image;
taking a second image of the positioning mark (11) after an electronic component (5) is mounted on the printed board (6);
determining a second position of the positioning mark (11) based on the second image;
comparing the first and second positions; and emitting a fault signal for a mounting operation and/or presentation to an operator.

8. The method of claim 7, wherein the fault signal stops the mounting operation of the electronic component when a difference between the first and second positions is out of a predetermined allowable range.

9. The method of claim 7, wherein the fault signal informs the operator of a difference between the first and second positions when the difference between the first and second positions is out of a predetermined allowable range.

10. The method of claim 9, wherein the informing of the difference comprises showing the operator the difference by a display (71).

11. The method of claim 9 or 10, wherein the informing of the difference comprises warning audibly the operator of the difference.

12. The method according to any of claims 7 to 11, further comprising storing the predetermined allowable range in a memory (62) before the electronic component (5) is mounted on the printed board (6).

13. The method according to any of claims 7 to 12, wherein the second image is taken after all electronic components (5) to be mounted on the printed board (6) are mounted on the printed board (6).
